# EUROPEAN PATENT APPLICATION

(11) **EP 2 264 802 A1**
(43) Date of publication of application: **22.12.2010**
(21) Application number: 09163272.9
(22) Date of filing: 19.06.2009
(51) Int. Cl.: H01L 41/18, H01L 41/22

(54) **Method for manufacturing a mainly film shaped piezoelectric element**

(71) Applicant: Nederlandse Organisatie voor Toegepast -Natuurwetenschappelijk Onderzoek TNO, 2628 VK Delft (NL)
(72) Inventor: van den Ende, Daan Anton, 3021 CJ Rotterdam (NL); Groen, Wilhelm Albert, 5626 GB Eindhoven (NL)
(74) Representative: Hatzmann, Martin

(57) **Abstract**

Method for manufacturing a mainly film shaped piezoelectric element, comprising a first and a second set of electrodes (1, 2) which extend mainly planar, parallel and alternately one another, the electrodes being connected with a layer of piezoelectric material, the method comprising the steps of providing the first and a second set of electrodes; providing a mixture of a fluid, uncured synthetic material and piezoelectric particles; providing a layer (3) of the mixture, interconnecting the electrodes of the first and second set of electrodes; performing a chain building sequence one or more times, the chain building sequence comprising: applying a DC voltage to the first and second set of electrodes, thus providing electric fields in the mixture layer between the AC electrodes of the first and second set of electrodes respectively causing alignment of the piezoelectric particles and forming particle chains between those electrodes, followed by removing the electric field applied to the first and second set of electrodes and/or applying an electric field in a direction substantially perpendicular to the plane of the first and second set of electrodes; and, finally, curing the mixture layer.

## Description

The present invention refers to a method for manufacturing a mainly film shaped piezoelectric element, comprising a first and a second set of electrodes which extend mainly planar, parallel and alternately one another, the electrodes being connected with a layer of piezoelectric material.

EP 1983584 discloses such a piezoelectric element in which the piezoelectric material comprises a plurality of fibers in juxtaposition. Conductive patterns are provided which form a pattern of interdigitated electrodes.

US5852337 discloses a piezoelectric film-type element including a piezoelectric operating layer constructed by successively and integrally forming and stacking, on a ceramic substrate, a single flat film-shaped lower electrode, a piezoelectric layer, and an upper electrode comprising a plurality of alternately arranged strip electrodes.

Due to their application of a ceramic substrate and their structure consisting of several layers (i.e. one ceramic substrate and two electrode layers), the strain characteristics of the known piezoelectric elements are limited and they are not very fit for applications, in which the elements need to bend under rather rough conditions, e.g. for harvesting strain energy in car tyres. In both US5852337 and EP1983584 the piezoelectric phase extends in at least one dimension and damage to the device, i.e. cracking, may occur due to the lower strain tolerance of this layer if the layer is a piezoelectric ceramic. A loss in electrical properties will occur as a result of this damage.

One aim of the present invention is to provide a method for manufacturing a mainly film shaped piezoelectric element having advanced reliability properties under rough conditions, especially with respect to tolerance against large deformation strains in the direction of the piezoelectric ceramic phase.

Another aim of the present invention is to provide a thinner film shaped piezoelectric element.

Yet another aim of the present invention is to provide a film shaped piezoelectric element having improved yield of electric power.

According to the present invention, in a method for manufacturing a mainly film shaped piezoelectric element, comprising a first and a second set of electrodes which extend mainly planar, parallel and alternately one another, the electrodes being connected with a layer of piezoelectric material, the following steps are preferred:
- providing said first and a second set of electrodes;
- providing a mixture of a fluid, uncured synthetic material and piezoelectric particles;
- providing a layer of said mixture, interconnecting the electrodes of said first and second set of electrodes;
- performing a chain building sequence one or more times, the chain building sequence comprising:
   - applying or increasing a DC voltage to the first and second set of electrodes, thus providing electric fields in said mixture layer between the AC electrodes of the first and second set of electrodes respectively causing alignment of the piezoelectric particles and forming particle chains between those electrodes;
   - removing or decreasing said electric field applied to the first and second set of electrodes and, optionally, applying an electric field in a direction mainly perpendicular to the plane of the electrodes, the electric field e.g. generated by at least one substantially pointed voltage electrode while grounding the first and second set of electrodes.
- curing the mixture layer.

The first and a second set of electrodes are preferred to comprise interdigitated electrodes in one plane provided on a provisional or permanent support layer. If provisional, it is removed after the last processing step; if permanent, it is not removed.

The mixture of a fluid, uncured synthetic material and piezoelectric particles may be provided to the same provisional or permanent support layer. The piezoelectric particles may contain e.g. barium titanate (BaTi03), lead titanate (PbTi03), lead zirconate titanate (Pb[ZrₓTi₁₋ₓ]O₃ 0<x<1; known as PZT and the most common piezoelectric ceramic in use today, sodium potassium niobate ([Naₓ K₁₋ₓ]NbO₃), lithium niobate (LiNb03), lithium tantalate (LiTa03), sodium bismuth titanate (N_{0.5} Bi_{0.5}]TiO3 sodium tungstate (Na2WO3), Ba2NaNb5O5 and/or Pb2KNb5O15. The aforementioned piezoelectric materials may be in their pure form or with added dopants, in the case of lead zirconate titanate this may be 0.1% to over 10% of elements such as La, Nb, Fe, Ni, Cu and Ba. In the case of sodium potassium niobate, this may be 0.1 to over 10% of elements such as Li or Ta. The particles may be spherical, ellipsoidal or polyhedral, such as are obtained by ball milling or various bottom up synthesis methods, such as the various types of nano-structured particles which may be fabricated from e.g. sol-gel precursors, such as platelets, whiskers or fibres.

It is provided, by any suitable method, that the layer of said mixture covers the electrodes of the first and second set of electrodes.

Next the following sequence is performed one or more times:
- Applying a DC or AC voltage to the first and second set of electrodes, thus providing electric fields in the mixture layer between the AC electrodes of the first and second set of electrodes respectively. This electric field will cause aligning of the piezoelectric particles and forming particle chains between those electrodes, which chains follow the electric field lines between the electrodes;
- Removing or decreasing the electric field applied to the first and second set of electrodes. Removing (or decreasing) the electric field causes the particle chains -provided that the mixture layer and thus the chains are (mainly) horizontally oriented- to sink and to settle upon each other, resulting in an increase of the concentration of piezoelectric particles, while largely maintaining their chained structure. Optional application of a DC electric field mainly perpendicular to the plane of the electrodes may enhance this settling behaviour. This electric field may for instance be generated by at least one substantially pointed voltage electrode while grounding the first and second set of electrodes. Alternatively, the bottom surface of the substrate layer may be provided with an electrode and a voltage may be applied to this electrode while grounding the first and second set of electrodes. In this case the applied electric field may also be an AC electric field. In either case, application of this perpendicular electric field will cause densification of the particle chains and cause a gradient in material properties.

The preceding steps may be repeated by applying again or by increasing the electric field over the first and second set of electrodes, and removing or decreasing it again, applying a perpendicular electric field etc., causing a continuation of the piezoelectric chain particle concentration in the region between the electrodes.

After the intended part chain particle concentration has been reached, the mixture layer is cured in any suitable way, e.g. chemically or thermally induced or by irradiating the synthetic fluid with ultraviolet light or by a combination of the above. After curing the mixture layer -which has been converted into a layer which contains a multitude of piezoelectric particle chains between the electrodes- has become solid. Depending on the particularly used materials, it may be possible to remove the original support layer which was provided provisionally for forming the proper piezoelectric layer including the planar electrodes. Without the support layer the piezoelectric element will have minimum thickness.

As will be elucidated hereinafter, the support layer may be provided with cavities between the electrodes, in order to provide room to the particle chains to be formed between the electrodes and providing that the chains will take a plane-symmetrical position.

Preferably, the electric field for particle alignment is generated by an AC voltage.

Preferably, a DC voltage is applied over the first and second set of electrodes after curing of the mixture causing poling of the piezoelectric particles between the electrodes.

Hereinafter the invention will be discussed in more detail with reference to some illustrative figures.
- Figures 1a and 1b: show an exemplary embodiment of a piezoelectric element in view from above and in view from aside;
- Figures 2a - 2f: show an illustration of the process according to the invention including one alternative embodiment.

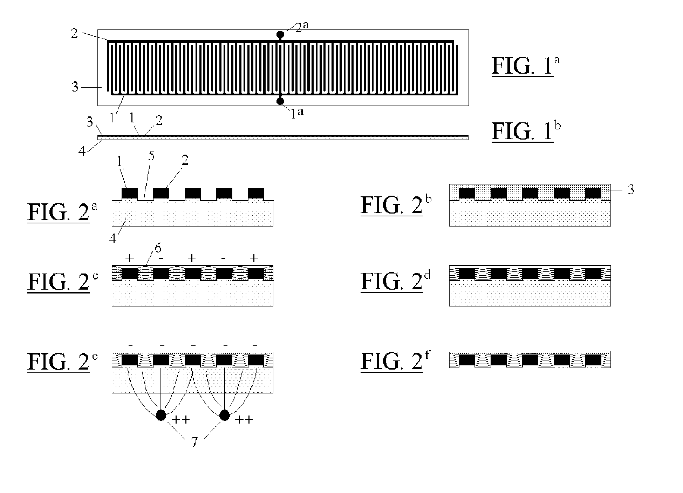

Figures 1a and 1b show a piezoelectric element which comprises a first and a second set of electrodes 1 and 2 respectively which extend mainly planar, parallel and alternately one another, and which are connected with a layer of piezoelectric material 3. The complete structure may be supported by a substrate or support layer 4. The method for manufacturing the film shaped piezoelectric element shown in figures 1a and 1b, comprising the following steps has been illustrated in figures 2a - 2f.

Figure 2a illustrates providing the first and a second set of electrodes 1 and 2 on support layer 4, which can be performed using any well-known process like electro-etching in which electrode material is etched away from the support layer 4. Besides, the support layer material 4 may be etched away partly, resulting in cavities 5 between the electrodes.

Figure 2b shows providing a layer of a mixture of a fluid, uncured synthetic material and piezoelectric particles, which mixture covers the electrodes 1 and 2 and fills the rooms between them.

Next sequence, illustrated in figures 2c and 2d, may be repeated one or more times. Figure 2c illustrates applying a DC voltage to the first and second (set of) electrodes 1 and 2, thus providing electric fields 6 in the mixture layer between those electrodes causing alignment of the piezoelectric particles and forming particle chains 6 between those electrodes. Figure 2d illustrates removing or decreasing the electric field applied to the first and second set of electrodes. Removing (or decreasing) the electric field will cause the particle chains 6 to sink (by gravitation) and to settle upon each other, resulting in an increase of the concentration of piezoelectric particles, while maintaining their chained structure. Those steps, illustrated in figures 2c and 2d are repeated by applying again or by increasing the electric field over the electrodes, and removing or decreasing that field again, etc., causing a continuation of the piezoelectric chain particle concentration process.

Optionally, this settling effect may be enhanced by application of a DC electric field in a direction substantially perpendicular to the plane of the first and second set of electrodes, which electric field will exert a mutual attractive force to the particle chains. While leaving their structure intact, this leads to a densification of the piezoelectric phase in the uncured fluid medium and so in a gradient in piezoelectric properties in the area between the first and second set of electrodes. The electric field is of sufficient strength to impart movement of the particle chains, but is not so strong that it causes breaking of the particle chains. This process is illustrated in figure 2e. The electric field may for instance be generated by at least one substantially pointed voltage electrode 7 while grounding the first and second set of electrodes. This configuration has the advantage that the perpendicular electric field may be applied to the device without having to include an extra electrode layer to the system. In this configuration the electric field between the electrodes 7 and 1 and 2 (which have ground potential) increases towards electrode 7. Due to that field increase the chain particles will experience a downward attraction force which cooperates with the gravitational force exerted to the chain particles.

The result of all this is a high concentration of piezoelectric particle chains between the electrodes, causing that -after the mixture layer 3 has been cured and the chain particles have been poled-, in practical operation, the piezoelectric effect is very effective, especially when experiencing compressive stress in the lateral direction, causing a large yield of electric output at the terminals la and 2a from which the "harvested" electric power can be collected when the piezoelectric element is subjected to mechanical deformations. Even though there is a high concentration of particle chains which have been formed between the electrodes, the mechanical properties of the piezoelectric element are still excellent compared with prior art film shaped piezoelectric elements, because the particles are held together by the relatively flexible matrix phase. This especially leads to greater resistance to cracking under tensile loading and thus fatigue tolerance.

Figure 2f illustrates that it may be preferred that the support layer 4 is removed -by any suitable means, e.g. by etching- after the mixture layer 3 has been cured.

Finally, it is noted that, preferably, the electric field for the particle alignment (i.e. chain forming) is generated by an AC voltage. An electric field, generated by a DC voltage over the electrodes is applied to the first and second set of electrodes after curing of the mixture, thus causing poling of the piezoelectric particles between the electrodes, which is necessary for the particles to act, together with the other particles in the piezoelectric chains between the electrodes, for piezoelectric electricity generation.

## Claims

1. Method for manufacturing a mainly film shaped piezoelectric element, comprising a first and a second set of electrodes (1, 2) which extend mainly planar, parallel and alternately one another, the electrodes being connected with a layer of piezoelectric material, the method comprising the following steps:
- providing said first and a second set of electrodes;
- providing a mixture of a fluid, uncured synthetic material and piezoelectric particles;
- providing a layer (3) of said mixture, interconnecting the electrodes of said first and second set of electrodes;
- performing a chain building sequence one or more times, the chain building sequence comprising:
- applying or increasing a DC voltage to the first and second set of electrodes, thus providing electric fields in said mixture layer between the AC electrodes of the first and second set of electrodes respectively causing alignment of the piezoelectric particles and forming particle chains between those electrodes;
- removing or decreasing said electric field applied to the first and second set of electrodes
- curing the mixture layer.

2. Method according to claim 1, or applying an electric field in a direction substantially perpendicular to the plane of the first and second set of electrodes.

3. Method according to claim 2, said electric field being generated by at least one substantially pointed electrode (7) while grounding the first and second set of electrodes.

4. Method according to claim 1, wherein the first and a second set of electrodes and the mixture of a fluid, uncured synthetic material and piezoelectric particles are applied on a support layer (4).

5. Method according to claim 4, wherein the support layer is provided with cavities (5) between the electrodes.

6. Method according to claim 4, wherein the support layer is maintained after the mixture layer has been cured.

7. Method according to claim 4, wherein the support layer is removed after the mixture layer has been cured.

8. Method according to claim 1, wherein the electric field for particle alignment is generated by an AC voltage.

9. Method according to claim 1, wherein a DC voltage is applied over the first and second set of electrodes after curing of the mixture causing poling of the piezoelectric particles between the electrodes.

10. Piezoelectric element, comprising a first and a second set of electrodes (1, 2) which extend mainly planar, parallel and alternately one another, the electrodes being connected with a layer of piezoelectric material, the piezoelectric element being manufactured by a method according to any preceding claim.
